Europäisches Patentamt

European Patent Office

Office européen des brevets

(11) Publication number: **0 507 021 A1**

# EUROPEAN PATENT APPLICATION

(21) Application number: **91302996.3**

(22) Date of filing: **04.04.91**

(51) Int. Cl.⁵: **H01R 23/68**, H01R 23/70

(43) Date of publication of application:
**07.10.92 Bulletin 92/41**

(84) Designated Contracting States:
**AT BE CH DE DK ES FR GB GR IT LI LU NL SE**

(71) Applicant: **DU PONT DE NEMOURS (NEDERLAND) B.V.**
**Baanhoekweg 22, P.O. Box 145**
**NL-3300 AC Dordrecht(NL)**

(72) Inventor: **Harding, John**
**1c Lode Avenue**
**Waterbach, Cambridge CB5 9PX(GB)**
Inventor: **Breeze, Gerald**
**7, Dry Brook Close, Balsall**
**Common, West Midlands CV7 7PY(GB)**

(74) Representative: **de Bruijn, Leendert C. et al**
**Nederlandsch Octrooibureau**
**Scheveningseweg 82 P.O. Box 29720**
**NL-2502 LS Den Haag(NL)**

(54) **System for electrically interconnecting component boards.**

(57) Device for electrically interconnecting component boards (14) provided with one or more contact elements (15) arranged at a board edge. The device comprises a connection network built up from connection boards (11), each provided with a wiring network (13) and with further contact elements (12) arranged at a board edge, which contact elements are electrically interconnected selectively via the wiring network (13). The connection boards (11) are arranged with their respective contact elements (12) situated at the same side and in a mutually parallel manner, so that the stacked contact elements (12) of the connection boards (11) can be contacted by the contact elements (15) of component boards (14) positioned orthogonally with respect to the connection boards. The contact elements (12, 15) preferably consist of plug-on connectors which are arranged at predetermined mutual distances on a component board (14) and a connection board (11).

EP 0 507 021 A1

Fig. 2

The invention relates to a device for electrically interconnecting component boards provided with one or more contact elements arranged at a board edge, which device comprises a connection network provided with one or more further contact elements, which one and further contact elements can be electrically coupled to one another detachably.

Devices for interconnecting boards carrying electrical and/or electronic circuit component are disclosed, inter alia, by the US Patent Specifications 3,963,301 and 4,703,394. The connection network is formed therein by a printed wiring board, also called the mother board, on the surface of which the contact elements are arranged in row and column form. The component boards, also called daughter boards, are positioned by means of their respective contact elements perpendicularly, transversely to the plane of the mother board. Contact elements for making contact to daughter boards may be provided on both surfaces of the mother board instead of on one surface.

In general, said mother boards have, partly depending on the field of application, large dimensions and are made up of a plurality of layers of electrically insulating materials having, confined between one or more adjacent layers, electrically conducting wiring tracks, for connecting respective contact elements, separate supply tracks and/or electrically conducting shielding layers.

Said mother boards should furthermore have an adequate mechanical rigidity to prevent breakage in wiring tracks as a consequence of flexural and tensile forces in the mother board on making contact to the daughter boards, or to be adequately supported mechanically. Depending on the type and the number of contact elements, relatively large forces may be exerted on the mother board during the coupling of the daughter boards. The risk of breakage in the wiring tracks increases as the dimensions and the number of contact elements of the mother board increase.

Such multilayer boards having printed wiring are relatively expensive compared with component boards having wiring provided on a surface thereof. In the event of damage to a mother board, it has to be repaired, which may be time-consuming, or to be replaced completely, which is expensive.

The invention is therefore based on the object of providing a device for electrically interconnecting component boards without making use of a mother board as described above.

According to the invention, this is achieved in that the connection network is made up of connection boards, each provided with a wiring network, the contact elements being arranged at an edge of a connection board and being electrically interconnected selectively via the wiring network, which connection boards, having their respective contact elements arranged so as to be situated on the same side, are stacked in a mutually parallel manner, so that the stacked contact elements of the connection boards can be contacted by the contact elements of component boards positioned orthogonally with respect to the connection boards.

Because the contact elements are arranged at the edge of the respective connection boards in the device according to the invention and the component boards are contacted by the connection boards with their edges orthogonal to the latter, virtually no flexural forces or, compared to a mother board according to the prior art, low flexural forces are exerted on the surfaces of the connection boards on contacting component boards. Partly because for each connection board, only a limited number of contact elements is contacted and the insertion force is distributed over the various connection boards when a component board is contacted. As a result of this, if printed wiring boards are used, the connection and component boards can be made of the same board material. Compared with a device according to the prior art, this means an appreciable cost saving for the device according to the invention.

The connection network according to the invention constructed as a stack of connection boards is very flexible as regards the replacement of damaged connection boards and also the alteration of connections. In the event of damage, the respective, per se relatively cheap connection board can be replaced, in contrast to a repair or even complete replacement of a mother board according to the prior art. In addition to a material cost saving, this also yields an appreciable saving in the repair cost and the time span during which a device is out of service for repair. Replacement of predetermined connections by others can easily be achieved by replacing the respective connection boards.

The invention furthermore provides a device in which the connection boards are provided with contact elements at two or more edges, for example for making contact to component boards at oppositely situated sides of the stack of connection boards.

In the preferred embodiment of the device according to the invention, the contact elements consist of plug-on connectors which are arranged at predetermined mutual distances on a component board and connection board, the mutual distance between the stacked connection boards corresponding to the mutual distance between the connectors on a component board or a multiple thereof.

A symmetrical entity is obtained by so arranging the connection boards that a row- and column-type array of connectors is formed. If desired, the connection boards may comprise different types of contact elements, for example so arranged that columns of contact elements of a particular type are formed.

In addition to achieving an electrical connection between the component boards and the connection boards, the connection boards are provided, in a further embodiment of the device according to the invention, with means for, for example, connecting a supply voltage for the component boards to be made contact to. If desired, in yet a further embodiment of the device according to the invention, the connection boards may also be provided with electrical and/or electronic circuit components, for example, for providing a stabilised supply voltage.

The device furthermore relates to a connection board and a component board constructed as a printed circuit board for use in the device according to the invention, and also to a rack system for mutually connecting component boards, comprising a frame provided with one or more stacks of connection boards according to the invention.

The invention is explained below with reference to a preferred embodiment shown in the drawing. In this connection:

Figure 1 shows, diagrammatically and in perspective, a mother/daughter board configuration known from the prior art in exploded view; and

Figure 2 shows, diagrammatically and in perspective, a portion of a device built up according to the invention.

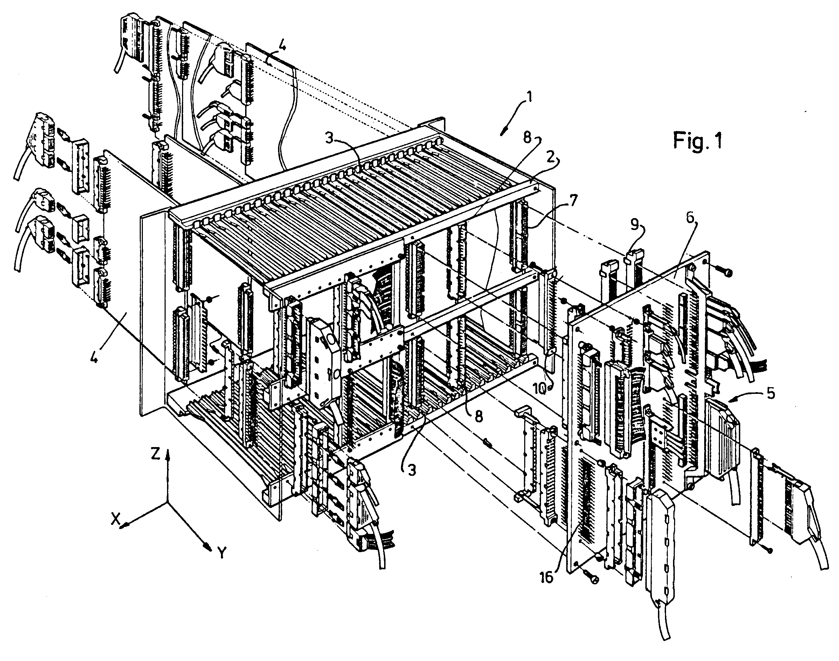

Figure 1 shows, in perspective and exploded view a rack 1, comprising a metal or plastic frame 2, provided with guide grooves 3 for receiving component boards 4, having printed wiring and a connection network 5 on a printed circuit board 6. In the assembled state, the printed circuit board 6 is mounted on the frame 2, as suggested by the dash-and-dot lines.

The printed circuit board 6, which is relatively thick compared with the component board 4 is composed of a plurality of layers of electrically insulating material between which separate wiring and supply tracks, and also shieldings made of electrically conducting material, are provided (not shown). On each side, the board 6 is provided with connectors of different types mounted thereon, as shown. The component boards 4 are provided at one edge with connectors 7, 8 which, in the assembled state, make contact to connectors 9 and 10, respectively, of the connection network 5.

With respect to the Cartesian coordinate system x, y, z shown in the figure, the component boards or daughter boards 4 are positioned with their plane parallel to the y,z plane and are offset mutually in the x direction. The board 6, also called a mother board, with the connection network 5 provided thereon, is arranged parallel to the x,z plane.

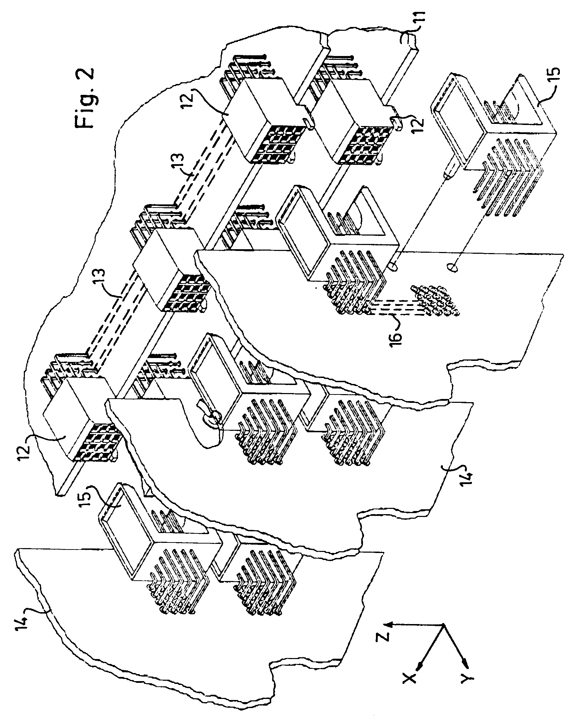

Figure 2 shows, diagrammatically and in perspective, a portion of a preferred embodiment of the device according to the invention, constructed as connection network consisting of a stack of printed circuit connection boards 11 arranged in parallel and provided with connectors 12, arranged at an edge thereof, the contact elements of which are electrically interconnected selectively via a wiring network in the form of wiring tracks 13 shown by means of broken lines. The wiring tracks 13 are situated on the face of the connection boards 11 which is not visible in the drawing. With respect to the Cartesian coordinate system x, y, z shown in the figure, the connection boards 11 are arranged so as to be mutually displaced in the z direction with their planes parallel to the x,y plane. The printed circuit component boards 14, provided at one edge with connectors 15 which can be electrically coupled detachably to the connectors 12 on the connection boards 11, are mutually offset in the x direction and positioned orthogonally with respect to the connection boards 11 with their planes parallel to the y,z plane.

The connection boards 11 form a row- and column-type array of contact elements, in which the connectors 12 situated in a row (x direction) form a connection network for the connectors 15, arranged in a corresponding row, of the component boards 14. A connection in a column (z direction) can be achieved via wiring tracks 16, shown by means of broken lines, on a component board 14.

Although not shown, the connection boards 11 can be provided at more than one edge with connectors 12 for making contact to a further group of component boards 14 and/or for electrically interconnecting one or more of the connection boards 11.

The invention is, of course, not limited to boards having connectors 12, 15 as shown, but the boards can, in principle, be fitted with any type of plug-on connector such as, for example, the connectors 7, 8, 9, 10 as shown in Figure 1. Instead of connectors, a grouping of contact elements 16 as shown in Figure 1 may also be used.

The connection boards 11 may furthermore be provided with means, for example a connector 12, for connecting a supply voltage for supplying the component boards 14. The supply voltage may, of course, also be provided via a component board 14 designed as a supply board.

One or more stacks of component boards 11 may furthermore be provided in a frame 2, as shown in Figure 1, to form a rack for contacting the component boards 4.

The invention is, of course, not limited to the embodiment shown, but can be modified in various ways and extended without deviating from the inventive idea, that is to say, contacting orthogonally connection boards 11 and component boards 14.

## Claims

1. Device for electrically interconnecting component boards provided with one or more contact elements arranged at a board edge, which device comprises a connection network provided with one or more further contact elements, which one and further contact elements can be electrically coupled to one another detachably, characterised in that the connection network is made up of connection boards, each provided with a wiring network, the contact elements being arranged at an edge of a connection board and being electrically interconnected selectively via the wiring network, which connection boards, having their respective contact elements arranged so as to be situated on the same side, are stacked in a mutually parallel manner, so that the stacked contact elements of the connection boards can be contacted by the contact elements of component boards positioned orthogonally with respect to the connection boards.

2. Device according to Claim 1, wherein the connection boards are provided with contact elements at two or more edges.

3. Device according to Claim 1 or 2, wherein the contact elements consist of plug-on connectors which are arranged at predetermined mutual distances on a component board and connection board, the mutual distance between the stacked connection boards corresponding to the mutual distance, or a multiple thereof, between the connectors on a component board.

4. Device according to Claim 3, wherein the connection boards form at least one row- and column-type array of connectors.

5. Device according to one or more of the preceding claims, wherein one or more connection boards comprise contact elements of different types.

6. Device according to one or more of the preceding claims, wherein at least one of the connection boards comprises means for connecting a supply voltage.

7. Device according to one or more of the preceding claims, wherein the connection boards are provided with circuit components.

8. Connection board according to one or more of the preceding claims, constructed as a printed circuit board.

9. Component board according to one or more of Claims 1 to 7 inclusive, constructed as a printed circuit board.

10. Rack for interconnecting component boards, comprising a frame provided with one or more stacks of connection boards according to one or more of Claims 1 to 8 inclusive.

Fig. 1

Fig. 2

EP 0 507 021 A1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | FR-A-1 554 841 (SAUTEL CIBERT)<br>* page 1, column 1, line 17 - line 35 *<br>* page 1, column 2, line 23 - line 30 *<br>* page 2, column 1, line 42 - line 48; figure 1 *<br><br>--- | 1,4 | H01R23/68<br>H01R23/70 |
| A | IBM TECHNICAL DISCLOSURE BULLETIN.<br>vol. 12, no. 4, September 1969, NEW YORK US<br>page 542;<br>JOHSON LOWRY: 'PRINTED FLEXOBLE CROSSOVER CONNECTOR'<br>--- | 1 | |
| A,D | EP-A-0 220 677 (ALCATEL)<br>--- | | |
| A,D | US-A-3 963 301 (STARK)<br><br>----- | | |
| | | | TECHNICAL FIELDS SEARCHED (Int. Cl.5 )<br><br>H01R<br>H05K |

The present search report has been drawn up for all claims

| Place of search | Date of completion of the search | Examiner |
|---|---|---|
| THE HAGUE | 06 DECEMBER 1991 | RUBENOWITZ A. |

EPO FORM 1503 03.82 (P0401)